# EUROPEAN PATENT APPLICATION

(11) **EP 3 316 307 A1**
(43) Date of publication of application: **02.05.2018**
(21) Application number: 15895955.1
(22) Date of filing: 25.06.2015
(51) Int. Cl.: H01L 27/32, H01L 51/52

(54) **METHOD FOR MANUFACTURING TOUCHSCREEN DISPLAY**

(71) Applicant: Shenzhen Royole Technologies Co., Ltd., Shenzhen, Guangdong 518172 (CN)
(72) Inventor: ZHANG, Jiaqi, Shenzhen Guangdong 518052 (CN); LIU, Zihong, Shenzhen Guangdong 518052 (CN)
(74) Representative: Maiwald Patentanwalts GmbH
(86) International application number: PCT/CN2015/082377
(87) International publication number: WO 2016/206055

(57) **Abstract**

A method for manufacturing a touchscreen display (100) comprises: S1, forming an OLED display layer (20) on a display substrate (10); S2, forming a touch layer (40) on a encapsulation substrate (30); and S3, encapsulating the OLED display layer (20) using the encapsulation substrate (30) so as to form the touchscreen display (100). The method for manufacturing a touchscreen display (100) reduces the size of the touchscreen display. In addition, the impact of the touch layer (40) on the encapsulating effect of the OLED display layer (20) can be avoided.

## Description

### FIELD

The present disclosure relates to a touchscreen display, and more particularly to a method for manufacturing a touchscreen display.

### BACKGROUND

In the field of flat panel displays, an organic electroluminescent display (Organic Light-Emitting Diode, OLED) has the following advantages:
1. Low cost of manufacturing equipment, and simple manufacture procedure;
2. Since the OLED may be self-luminous, there is no need to use light source elements, and thus reducing the size of the display.

Therefore, the OLED is favored by people more and more, and becomes the flat panel display which may be widely used at current and in the future.

On the other hand, at present the touchscreen is a simple, convenient, natural input device, and has the following advantages such as a high abrasion resistance, s fast response, a small size and convenient communication. Users can directly input information on the surface of the display device equipped with a touchscreen by clicking or handwriting, thus the man-machine interaction is straightforward, and friendlier and more convenient compared with the input devices such as a mouse and a keyboard. Therefore the OLED is more and more widely used in the display of various portable devices (e.g., a mobile phone, a personal digital assistant (PDA)) to constitute a touchscreen display.

However, in the touchscreens of the prior art, two electrodes are disposed on two sides of the same substrate respectively or on two different substrates respectively, and the touchscreens are all manufactured as a separate device. Thus, the touchscreen displays of the prior art are produced mainly by assembling a finished product of the separately produced touchscreen with a finished product of a display such as a liquid crystal display, a plasma display, an OLED by fitting closely in a mechanical manner with a double sided adhesive or optical glue.

As the touchscreen is widely used, an OLED touchscreen display integrating a touchscreen and an OLED display is favored as well. However, the current OLED touchscreen display device is still mainly implemented by integrating the touchscreen and OLED display in the mechanical fitting manner. Due to the advantage of OLED being self-luminous, the OLED touchscreen display formed by assembling the touchscreen with OLED display together does not need a backlight. On this basis, the OLED touchscreen display has a significant advantage in the thickness compared with the touchscreen display by assembling traditional display such as LCD and the like, however, the thickness of the OLED touchscreen display is still increased by doubling the thickness of the OLED display as the separate touchscreen is included in the OLED touchscreen display. Meanwhile, when touchscreen is fitted with the OLED display in a mechanical manner, the touchscreen substrate may be adhered to the OLED display substrate unevenly, thus leading to the problems of rainbow and Newton ring. Moreover, the presence of the gas or optical glue between the touchscreen and the OLED display substrate causes lower transmittance. The above drawbacks not only increase the cost of OLED touchscreen display greatly, but also hardly meet the requirements of people for pursuing an ultra-thin touchscreen.

### SUMMARY

The present disclosure seeks to solve at least one of the problems that exist in the related art to at least some extent. Accordingly, the present disclosure provides a method for manufacturing a touchscreen display.

The method for manufacturing a touchscreen display according to an embodiment of the present disclosure includes:
S1, forming an OLED display layer on a display substrate;
S2, forming a touch layer on a encapsulation substrate; and
S3, encapsulating the OLED display layer by using the encapsulation substrate to form the touchscreen display.

According to the method for manufacturing the touchscreen display in an embodiment of the present disclosure, the touch layer is directly formed on the encapsulation substrate for encapsulating an OLED display layer, and thus the size of the touchscreen display is reduced compared with a touchscreen display manufactured by the traditional method in which a touch layer is formed on a separate substrate and then adhered with a encapsulated OLED display layer.

On the other hand, compared with the method in which the OLED display layer is first encapsulated by the encapsulation substrate and then the touch layer is formed on the encapsulation substrate, the method of present disclosure in which the touch layer is formed on the encapsulation substrate and then a OLED display layer is encapsulated by the encapsulation substrate can avoid the influence of the formation of the touch layer on the effect of encapsulating the OLED display layer. For example, the adhering strength between the encapsulation substrate and the OLED may be decreased, or if the touch layer is formed by wet etching, it may be necessary to re-dry the entire touchscreen display after the touch layer is formed.

Additional aspects and advantages of embodiments of the present disclosure will be given in part in the following descriptions, become apparent in part from the following descriptions, or be learned from the practice of the embodiments of the present disclosure.

### BRIEF DESCRIPTION OF THE DRAWINGS

These and other aspects and advantages of embodiments of the present disclosure will become apparent and more readily appreciated from the following descriptions made with reference to the drawings as described below.
Fig. 1 is a schematic view of a touchscreen display manufactured by a method for manufacturing a touchscreen display according to an embodiment of the present disclosure.
Fig. 2 is a schematic view of a display substrate and an OLED display layer used by a method for manufacturing a touchscreen display according to an embodiment of the present disclosure.
Fig. 3 is a schematic plan view of a encapsulation substrate and a touch layer used by a method for manufacturing a touchscreen display according to an embodiment of the present disclosure.

### DETAILED DESCRIPTION

Reference will be made in detail to embodiments of the present disclosure. The embodiments described herein with reference to drawings are explanatory, illustrative, and used to generally understand the present disclosure. The embodiments shall not be construed to limit the present disclosure. The same or similar elements and the elements having same or similar functions are denoted by like reference numerals throughout the descriptions.

In the specification, it is to be understood that terms such as "central", "longitudinal", "lateral", "length", "width", "thickness", "upper", "lower", "front", "rear", "left", "right", "vertical", "horizontal", "top", "bottom", "inner", "outer", "clockwise", and "counterclockwise" should be construed to refer to the orientation as then described or as shown in the drawings under discussion. These relative terms are for convenience of description and do not require that the present disclosure be constructed or operated in a particular orientation. In addition, terms such as "first" and "second" are used herein for purposes of description and are not intended to indicate or imply relative importance or significance or to imply the number of indicated technical features. Thus, the feature defined with "first" and "second" may include one or more of this feature. In the description of the present disclosure, "a plurality of" means two or more than two, unless specified otherwise.

In the description of the present disclosure, it should be understood that, unless specified or limited otherwise, the terms "mounted," "connected," "coupled" and "fixed" and variations thereof are used broadly and encompass such as mechanical or electrical mountings, connections and couplings, also can be inner mountings, connections and couplings of two components, and further can be direct and indirect mountings, connections, and couplings, which can be understood by those skilled in the art according to the detail embodiment of the present disclosure.

In the present disclosure, unless specified or limited otherwise, a structure in which a first feature is "on" or "below" a second feature may include an embodiment in which the first feature is in direct contact with the second feature, and may also include an embodiment in which the first feature and the second feature are not in direct contact with each other, but are contacted via an additional feature formed therebetween. Furthermore, a first feature "on," "above," or "on top of" a second feature may include an embodiment in which the first feature is right or obliquely "on," "above," or "on top of" the second feature, or just means that the first feature is at a height higher than that of the second feature; while a first feature "below," "under," or "on bottom of" a second feature may include an embodiment in which the first feature is right or obliquely "below," "under," or "on bottom of" the second feature, or just means that the first feature is at a height lower than that of the second feature.

Various embodiments and examples are provided in the following description to implement different structures of the present disclosure. In order to simplify the present disclosure, certain elements and settings will be described. However, these elements and settings are only by way of example and are not intended to limit the present disclosure. In addition, reference numerals may be repeated in different examples in the present disclosure. This repeating is for the purpose of simplification and clarity and does not refer to relations between different embodiments and/or settings. Furthermore, examples of different processes and materials are provided in the present disclosure. However, it would be appreciated by those skilled in the art that other processes and/or materials may be also applied.

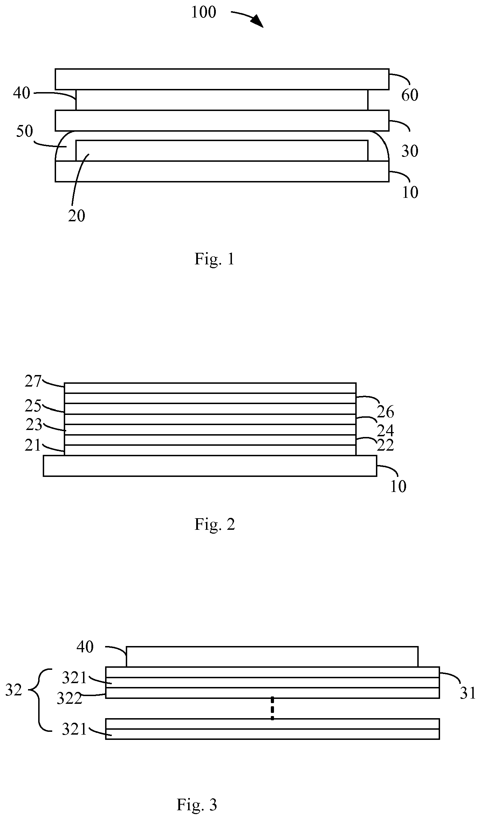

Referring to Figure 1, a method for manufacturing a touchscreen display 100 according to an embodiment of the present disclosure includes the steps of:
S1, forming an OLED display layer 20 on a display substrate 10;
S2, forming a touch layer 40 on a encapsulation substrate 30; and
S3, encapsulating the OLED display layer 20 by using the encapsulation substrate 30 to form the touchscreen display 100.

According to the method for manufacturing a touchscreen display 100 in an embodiment of the present disclosure, the touch layer 40 is directly formed on the encapsulation substrate 30, and thus the size of the touchscreen display 100 is reduced compared with a touchscreen display manufactured by the traditional method in which a touch layer is formed on a separate substrate and then adhered with a encapsulated OLED display layer.

On the other hand, compared with a method in which the OLED display layer 20 is first encapsulated by the encapsulation substrate 30 and then the touch layer 40 is formed on the encapsulation substrate 30, the method of present disclosure in which the touch layer 40 is formed on the encapsulation substrate 30 and then the OLED display layer 20 is encapsulated by the encapsulation substrate 30 can avoid the influence of the formation of the touch layer 40 on the effect of encapsulation the OLED display layer 20. For example, the adhering strength between the encapsulation substrate 30 and the OLED display layer 20 may be decreased, or if the touch layer 40 is formed by wet etching, it may be necessary to re-dry the entire touchscreen display 100 after the touch layer 40 is formed.

It would be appreciated that in the method of the present disclosure, steps S1 and S2 are not limited to be performed in a numerical order. That is, the method according to embodiments of the present disclosure includes, but is not limited to, steps in the order of S1, S2 and S3, and the method may also include steps in an order of S2, S1 and S3.

Specifically, the display substrate 10 is a flexible substrate, for example, a polyethylene terephthalate (PET) film or a polyethylene naphthalate (PEN) film. As such, the OLED display layer 20 is formed on the display substrate 10 as a flexible display device.

Referring to Figure 2, the OLED display layer 20 includes an anode pattern layer 21, a hole injection layer 22, a hole transport layer 23, a light emitting layer 24, an electron transport layer 25, an electron injection layer 26, and a cathode pattern layer 27, which are stacked sequentially at the display substrate 10 by vapor deposition, printing, or coating. As such, when a direct current is applied between the anode pattern layer 21 and the cathode pattern layer 27, electrons can be driven from the electron injecting layer 26 to the electron transport layer 25 and holes can be driven from the hole injection layer 22 into the light emitting layer 24 through the hole transport layer 23, thus combining the electrons and the holes, i.e., an electron-hole capture is formed. Being excited by the energy released from the electron-hole capture, the chemical molecules of the light emitting layer 24 emits light to achieve the purpose of display.

It would be appreciated that the OLED display layer 20 is not limited to the present embodiment and may also have other stacked structures known to those skilled in the art.

Referring to Figure 3, in this embodiment, the encapsulation substrate 30 includes a barrier substrate 31 and a barrier layer 32. Step S2 includes:
S31, forming a barrier layer 32 on a barrier substrate 31 to obtain the encapsulation substrate 30; and
S32, forming the touch layer 40 on one side of the barrier substrate 31 away from the barrier layer 32.

Specifically, the barrier substrate 31 is a flexible substrate, for example, a polyethylene terephthalate (PET) film or a polyethylene naphthalate (PEN) film. As such, the barrier layer 32 may be formed on the barrier substrate 31 to provide a flexible encapsulation substrate 30, while the touch layer 40 may be formed on the encapsulation substrate 30 to provide a flexible touchscreen device, and the flexible display device is combined with the flexible touchscreen device to provide a flexible touchscreen display 100.

The barrier layer 32 includes an inorganic barrier material layer 321 (e.g. aluminum oxide, silicon oxide, silicon nitride or the like) formed on the barrier substrate 31. After the OLED display layer 20 is encapsulated by the encapsulation substrate 30, water or oxygen may be prevented from entering into the OLED display layer 20 due to densification of the inorganic barrier material layer 321, thus avoiding damage to the OLED display layer 20.

However, structural defects may easily occur in the inorganic barrier material layer 321 at a low temperature, therefore in some embodiments, the barrier layer 32 also includes organic and inorganic material layers of a multilayered structure, for example, an organic material performance layer 322 is formed on the inorganic barrier material layer 321 for overcoming the structural defects present in the inorganic barrier material layer 321.

Preferably, another inorganic barrier material layer 321 is superimposed on the organic material performance layer 322.

It would be appreciated that the barrier layer 32 may include a plurality of organic material performance layers 322 and inorganic barrier material layers 321 disposed alternately. Since the organic material performance layer 322 is present as a filler, an outermost layer of the structure of the barrier layer 32 is generally the inorganic barrier material layer 321.

In step S32, the touch layer 40 is formed from an indium tin oxide material by a wet etching process. Alternatively, in other embodiments, the touch layer 40 is formed from a silver nanowire material by a screen printing process. In further embodiments, the touch layer 40 is formed from a metal mesh material or a graphene material by a laser sintering process. If the laser sintering process is used, since the laser energy is pulsed, sintering can be achieved by the instantaneous energy compared to the conventional dry etching process and the barrier layer 32 may not be damaged.

In another embodiment, step S2 may further include:
S41, forming the touch layer 40 on a barrier substrate 31;
S42, forming a barrier layer 32 on one side of the barrier substrate 31 away from the touch layer 40.

As such, the barrier layer 40 is formed on the barrier substrate 31, and then the barrier layer 32 is stacked, thus reducing drying time.

In step S3, the encapsulation substrate 30 is adhered by a flat pressing process to the OLED display layer 20 using an adhesive material 50, so as to encapsulate the OLED display layer. In combination with the above embodiments, it is possible that one side of the barrier layer 30 away from the touch layer 40 is adhered to the OLED display layer 20 by the adhesive material 50. It is also possible that the inorganic barrier material layer 321 being the outermost layer of the encapsulation substrate 30 is adhered with flat pressing to the OLED display layer 20 by the adhesive material 50.

Referring to Figure 1, in some embodiments, for example, the method for manufacturing a touchscreen display further includes: S4, forming a polarizer 60 on the touch layer 40.

As an example, a release film of the polarizer 50 may be peeled off and adhered on the touch layer 40.

The polarizer 50 may be used as a polarizer of the OLED display layer 20 on one hand, and used as a surface protective film of the touch layer 40 on the other hand.

Reference throughout this specification to "an embodiment," "some embodiments," "one embodiment", "another example," "an example," "a specific example," or "some examples," means that a particular feature, structure, material, or characteristic described in connection with the embodiment or example is included in at least one embodiment or example of the present disclosure. Thus, the appearances of the phrases such as "in some embodiments," "in one embodiment", "in an embodiment", "in another example," "in an example," "in a specific example," or "in some examples," in various places throughout this specification are not necessarily referring to the same embodiment or example of the present disclosure. Furthermore, the particular features, structures, materials, or characteristics may be combined in any suitable manner in one or more embodiments or examples.

Although explanatory embodiments have been shown and described, it would be appreciated by those skilled in the art that the above embodiments cannot be construed to limit the present disclosure, and changes, alternatives, and modifications can be made in the embodiments without departing from spirit, principles and scope of the present disclosure.

## Claims

1. A method for manufacturing a touchscreen display, comprising:
S1, forming an OLED display layer on a display substrate;
S2, forming a touch layer on a encapsulation substrate; and
S3, encapsulating the OLED display layer by using the encapsulation substrate to form the touchscreen display.

2. The method according to claim 1, wherein the display substrate is a flexible substrate.

3. The method according to claim 1, wherein the display substrate is a polyethylene terephthalate film or a polyethylene naphthalate film.

4. The method according to claim 1, wherein the step S2 comprises:
S31, forming a barrier layer on a barrier substrate to obtain the encapsulation substrate; and
S32, forming the touch layer on one side of the barrier substrate away from the barrier layer.

5. The method according to claim 1, wherein the step S2 comprises:
S41, forming the touch layer on a barrier substrate;
S42, forming a barrier layer on one side of the barrier substrate away from the touch layer.

6. The method according to claim 4 or 5, wherein the display substrate is a flexible substrate.

7. The method according to claim 4 or 5, wherein the display substrate is a polyethylene terephthalate film or a polyethylene naphthalate film.

8. The method according to claim 4 or 5, wherein the barrier layer comprises an inorganic barrier material layer made of aluminum oxide, silicon oxide or silicon nitride.

9. The method according to claim 4 or 5, wherein the barrier layer comprises organic and inorganic material layers of a multilayered structure.

10. The method according to claim 1, wherein the touch layer is formed from an indium tin oxide material by a wet etching process, or formed from a silver nanowire material by a screen printing process, or formed from a metal mesh material or a graphene material by a laser sintering process.

11. The method according to claim 1, wherein in the step S3, the encapsulation substrate is adhered with flat pressing to the OLED display layer by an adhesive material, so as to encapsulate the OLED display layer.

12. The method according to claim 1, further comprising:
S4, forming a polarizer on the touch layer.
